# FASCICULE DE BREVET EUROPEEN

(11) **EP 0 522 938 B1**
(45) Date de publication et mention de la délivrance du brevet: **31.01.1996**
(21) Numéro de dépôt: 92401909.4
(22) Date de dépôt: 03.07.1992
(51) Int. Cl.: H01L 21/337, H01L 29/808

(54) **Procédé de fabrication d'un transistor à effet de champ vertical, et transistor obtenu par ce procédé**
Verfahren zum Herstellen eines vertikalen Feldeffekt-Transistors und durch dieses Verfahren hergestellter Transistor
Method for fabrication of a vertical field effect transistor and transistor obtained by this method

(30) Priorité: 10.07.1991 FR 9108677
(43) Date de publication de la demande: 13.01.1993
(73) Titulaire: FRANCE TELECOM, F-75015 Paris (FR)
(72) Inventeur: Chantre, Alain, F-38120 Saint-Egreve (FR); Bois, Daniel, F-38330 Saint-Ismier (FR); Nouailhat, Alain, 38130 Echirolles (FR)
(74) Mandataire: Doireau, Marc

(56) Documents cités:
- EP-A- 0 069 606
- EP-A- 0 069 606
- IBM TECHNICAL DISCLOSURE BULLETIN vol. 25, no. 3A, Août 1982, NEW YORK USA pages 981 - 982 S. P. GAUR ET AL. 'vertical jfet integrated with self-aligned bipolar process'

## Description

La présente invention concerne un procédé de fabrication d'un transistor à effet de champ vertical.

D'une manière générale, un transistor à effet de champ vertical se distingue d'un transistor à effet de champ classique par le fait que le canal conducteur s'étend globalement perpendiculairement au substrat, ce qui présente notamment l'avantage de permettre une meilleure intégration d'un tel transistor dans des circuits intégrés.

Dans les transistors à effet de champ verticaux actuellement fabriqués, la grille de commande est formée soit par implantation ionique (transistors JFET), soit par dépôt métallique (transistors à base perméable) au fond de tranchées gravées dans le semi-conducteur.

Sur le plan de la fabrication, une opération d'implantation ionique pour former la grille de commande d'un transistor à effet de champ vertical est moins délicate à réaliser qu'une opération de métallisation. Sur le plan des performances, en particulier dans le domaine des vitesses de commutation, une grille de commande métallisée donne de meilleurs résultats qu'une grille formée par implantation ionique du fait de la moindre résistivité présentée par une grille métallisée. Par contre, une grille formée par implantation ionique permet d'obtenir de bonnes caractéristiques de redressement.

Le document EP-A-0 069 606 décrit un procédé de fabrication d'un transistor à effet de champ vertical à jonction, selon lequel une couche de silicium polycristallin est constituée de trois couches ayant des dopages différents pour obtenir, après attaque chimique, une région de source délimitée entre des rails ayant une forme de diabolo, et selon lequel les contacts de grille et de source sont obtenus par métallisation, sachant que la forme en diabolo des rails permet d'éviter toute continuité entre les métallisations de grille et de source.

A cet effet, l'invention propose un procédé de fabrication d'un transistor à effet de champ vertical selon la revendication 1.

D'une manière générale, pour former la région de source du transistor, le procédé consiste à déposer une couche photosensible sur la couche de silicium polycristallin dopé et à réaliser des opérations de masquage et de photogravure pour éliminer ensuite la couche photosensible et le silicium polycristallin de part et d'autre de la région de source.

L'opération qui consiste à former un siliciure de métal sur la région de grille et sur la région de source est avantageusement réalisée par un procédé salicide, connu en soi, mais elle peut aussi être réalisée par un dépôt sélectif d'un composé métallique.

Enfin, les opérations d'implantation ionique pour former la région de grille et de formation des siliciures des régions de source et de grille sont réalisées d'une manière auto-positionnée par rapport à la source en saillie à la face principale du substrat. Ainsi, il n'est pas nécessaire de recourir à l'utilisation de masques classiques qu'il faut positionner et aligner correctement au cours de manipulations délicates à réaliser.

Un tel procédé de fabrication correspond globalement à la réalisation d'un transistor à effet de champ vertical simple ou élémentaire qui satisfait les objectifs visés par l'invention.

A partir de cette structure élémentaire, l'invention prévoit également la possibilité de réaliser une version perfectionnée pour aboutir à un transistor ayant notamment de bonnes caractéristiques de fonctionnement en hyperfréquences.

Aussi, le procédé selon l'invention consiste également, après l'étape de formation des espaceurs, à faire une attaque chimique de la zone dopée du substrat formant initialement la zone active de grille, afin de creuser un espace à la face inférieure des espaceurs, de manière à ce que lors de l'opération de dépôt sélectif de siliciure qui suit, du métal vienne combler ces espaces préalablement dégagés. Après l'opération de dépôt sélectif de siliciure, une nouvelle implantation ionique de dopant de type de conductivité opposé au type de conductivité prédéterminé est réalisée au travers du siliciure pour reformer la jonction de la région de grille.

Ainsi, il est possible de réaliser un transistor à effet de champ vertical dont la grille de commande présente une résistivité moindre, ce qui permet d'améliorer les performances de fonctionnement d'un tel transistor.

Selon un autre avantage d'un transistor fabriqué selon le procédé conforme à l'invention chaque étape nécessaire à sa fabrication peut être réalisée selon des techniques classiques utilisées notamment pour la fabrication des transistors MOS où par analogie la zone active de grille est en saillie sur la face principale du substrat. Il en résulte un transistor qui peut être facilement intégré dans des technologies MOS, notamment CMOS, pour former des composants mixtes JFET/CMOS par exemple.

D'autres avantages, caractéristiques et détails de l'invention ressortiront de la description explicative qui va suivre faite en référence aux dessins annexés donnés uniquement à titre d'exemple, dans lesquels :
- la figure 1 est une vue schématique de principe de la structure de la grille de commande d'un transistor à effet de champ vertical,
- les figures 2a à 2d sont des vues en coupe schématiques montrant les principales étapes de fabrication d'un transistor à effet de champ à canal N selon une version élémentaire réalisée à partir d'un substrat ayant un type de conductivité N,
- la figure 3 est une vue en coupe d'un transistor à effet de champ vertical obtenu selon le procédé à partir d'un substrat ayant un type de conductivité P,
- les figures 4a à 4d sont des vues en coupe pour illustrer les principales étapes d'une variante du procédé de fabrication conforme à l'invention d'un transistor à effet de champ vertical à canal N,
- et la figure 5 est une vue en coupe d'un transistor à effet de champ vertical obtenu selon la variante du procédé conforme à l'invention à partir d'un substrat ayant un type de conductivité P.

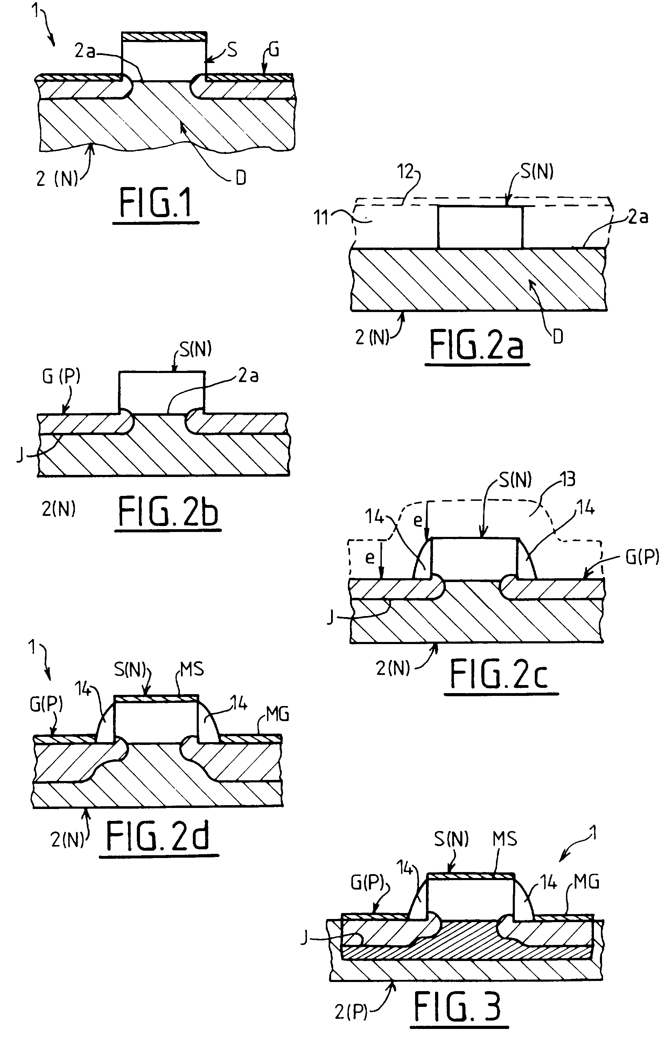

D'une manière générale, en se reportant à la figure 1, il est représenté la structure de base d'une grille de commande d'un transistor à effet de champ vertical à canal N.

Un tel transistor à effet de champ vertical 1 est réalisé à partir d'un substrat semi-conducteur tel qu'un substrat 2 en silicium, et il comprend une région active de drain D réalisée dans le substrat 2, une région active de source S réalisée en saillie sur une face principale 2a du substrat 2, et une région active de grille G réalisée au niveau de la face 2a du substrat 2 de part et d'autre de la région de source S.

On va décrire maintenant en référence aux figures 2a à 2e le procédé de fabrication du transistor ayant la structure représentée à la figure 1.

En se reportant à la figure 2a, sur un substrat 2 en silicium préalablement dopé avec des impuretés N pour lui donner un type de conductivité donné N, on dépose dans une première étape et d'une façon connue en soi, une couche 11 de silicium polycristallin sur une face principale 2a du substrat 2.

Dans une seconde étape illustrée également à la figure 2a, on dépose une couche photosensible 12 sur la couche 11 de silicium polycristallin, puis on élimine par une opération de photolithogravure la couche photosensible 12 et la couche 11 de silicium polycristallin de part et d'autre de la source S qui se trouve ainsi en saillie à la surface du substrat 2.

L'élimination de la couche 11 de silicium polycristallin est avantageusement réalisée par une opération de gravure ionique réactive pour donner à la région de source S des parois latérales perpendiculaires à la face principale 2a du substrat.

Dans une troisième étape illustrée à la figure 2b, on effectue une implantation ionique de dopant accepteur de type P tel que du bore dans le substrat 2 de part et d'autre de la source S pour former la région de grille G avec la jonction J. Cette implantation s'effectue d'une façon connue en soi, mais la source S en saillie est avantageusement utilisée comme masque lors de l'opération d'implantation. Ainsi, l'implantation s'effectue d'une manière auto-positionnée par rapport à la source S.

A la fin de cette opération d'implantation, on effectue une opération de recuit pour diffuser plus profondément les ions de bore à l'intérieur du substrat 2.

Dans une quatrième étape illustrée à la figure 2c, on réalise la protection des parois latérales de la source S que l'on recouvre d'un isolant tel que l'oxyde de silicium SiO₂.

Pour cela, on dépose une couche 13 d'oxyde de silicium sur la face 2a du substrat 2 sur une épaisseur e, et on effectue ensuite une gravure anisotrope également sur une épaisseur e pour obtenir l'élimination de l'oxyde de silicium sauf dans les parties adjacentes aux parois latérales de la source S. Il est ainsi formé des parties isolantes dénommées espaceurs 14 qui ont notamment pour fonction de protéger la région de source S en saillie sur le substrat 2.

Dans une cinquième étape illustrée à la figure 2d, on procède à une nouvelle implantation ionique de type P pour augmenter le dopage de grille et à la siliciuration de la source S et de la grille G, cette dernière opération s'effectuant avantageusement d'une manière auto-positionnée par rapport à la source S utilisée comme masque.

L'opération de siliciuration qui peut être réalisée par tout procédé connu en soi, comme par exemple par dépôt sélectif d'un composé métallique sur la zone de grille G et sur la zone de source S à l'exception des espaceurs 14 qui recouvrent les parois latérales de la zone de source S, est de préférence réalisée par un procédé salicide. Un tel procédé consiste à déposer une couche métallique en titane par exemple sur la face principale 2a du substrat 2, à réaliser une opération de recuit pour que le métal réagisse au contact des parties en silicium du substrat et de la source pour former un siliciure de titane TiS₂ sauf sur les parois latérales de la source 2 en oxyde de silicium, et à éliminer ensuite la couche de métal au niveau des espaceurs 14. On obtient ainsi les zones siliciurées de grille MG et de source MS.

D'une manière générale, les principales étapes du procédé qui viennent d'être décrites en référence aux figures 2a à 2d permettent d'obtenir un transistor à effet de champ vertical ayant une structure élémentaire telle que celle représentée à la figure 2d, c'est-à-dire un transistor dans lequel la région de grille G est formée par une implantation ionique dans le substrat et d'une siliciuration de la partie implantée.

La figure 3 est une vue en coupe qui illustre schématiquement la structure d'un transistor à effet de champ vertical à canal N qui se différencie de celui représenté à la figure 2d uniquement par le fait que le substrat 2 est un substrat ayant un type de conductivité P. Dans ce cas, le procédé de fabrication du transistor tel que décrit précédemment comprend une étape préliminaire qui consiste à faire une implantation ionique dans le substrat 2 avec des impuretés de type N, telles que des ions phosphore, pour former la zone active de drain D, cette zone constituant ce qui est communément appelé un caisson.

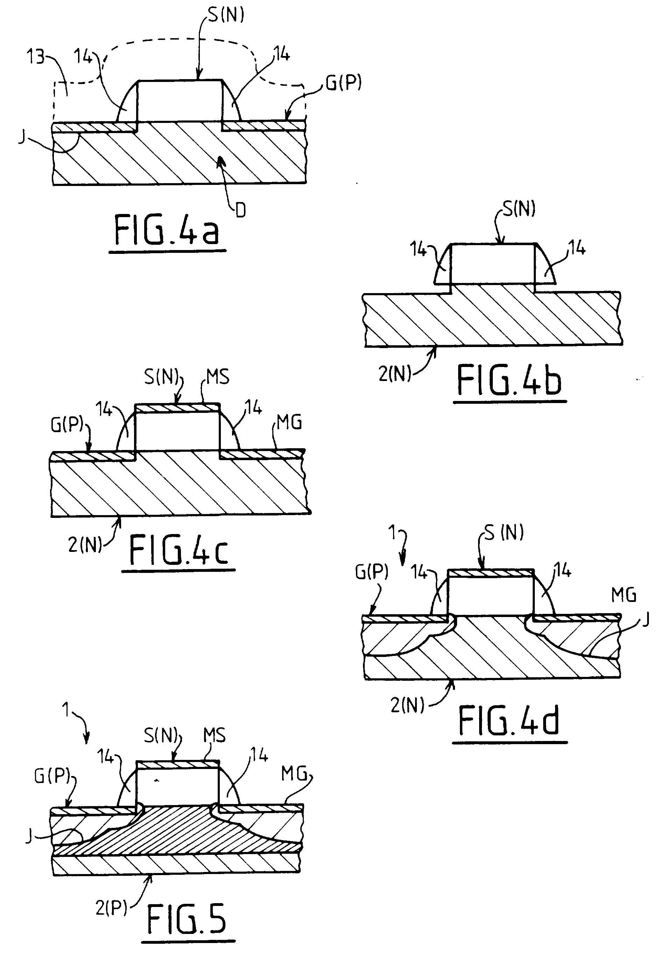

Selon le procédé conforme à l'invention, il est possible de réaliser un transistor à effet de champ vertical perfectionné présentant une résistance de grille inférieure pour lui conférer de meilleures performances, notamment dans le domaine des hyperfréquences. Ce procédé de fabrication est illustrée aux figures 4a à 4d décrites ci-après. Les premières étapes du procédé de fabrication jusqu'à la formation des espaceurs 14 sont semblables à celles décrites précédemment en référence aux figures 2a à 2c, et la figure 4a correspond globalement à la figure 2d, à la nuance près que l'implantation ionique pour constituer la région de grille G n'est que superficielle.

Ensuite, dans une étape telle qu'illustrée à la figure 4b, on procède à l'élimination de cette zone implantée de manière à creuser le substrat 2 sous les espaceurs 14 situés de part et d'autre de la région de source S. Cette élimination de la zone implantée est effectuée par une dissolution anodique qui est sélective par rapport à la partie dopée N du substrat 2. C'est pour cette raison qu'il a fallu faire une implantation initiale avant la formation des espaceurs pour permettre cette attaque chimique.

Enfin, dans une dernière étape représentée aux figures 4c et 4d, on effectue l'opération de siliciuration par dépôt sélectif avant d'effectuer une nouvelle implantation ionique de dopant accepteur de type P tel que du bore pour reformer à l'intérieur du substrat 2 la jonction J. Cette implantation est choisie de façon à ne pas faire varier les performances de la source.

Sur la figure 5, il est représenté un transistor à effet de champ vertical obtenu selon la variante du procédé, dans le cas où le substrat 2 est dopé P, ce qui nécessite, comme pour le transistor représenté à la figure 3, de réaliser avant la gravure de la région de source S, une implantation ionique pour réaliser un caisson de type N.

Bien entendu, le procédé tel que décrit précédemment pour la fabrication d'un transistor à effet de champ vertical à canal N s'applique également dans le cas d'un transistor à canal P en faisant aussi la nuance entre un substrat ayant un type de conductivité N ou P.

D'une manière générale, chaque étape du processus de fabrication d'un transistor à effet de champ vertical selon l'invention fait intervenir des opérations qui sont couramment effectuées dans la fabrication des transistors, en particulier des transistors CMOS. En effet, si on se reporte à la figure 3, le transistor à effet de champ vertical présente une structure qui, par analogie, est voisine d'un transistor PMOS dont la couche d'oxyde de silicium prévue entre la région active de grille et le substrat a été supprimée.

Dans ces conditions, le transistor à effet de champ fabriqué selon l'invention peut être facilement intégré dans des technologies MOS, en particulier CMOS, pour réaliser des composants mixtes, certaines opérations de fabrication de plusieurs transistors différents pouvant être faites simultanément, comme par exemple la région active de source d'un transistor selon l'invention et la région active de grille d'un transistor PMOS.

Il est à noter également une certaine analogie du transistor à effet de champ fabriqué selon l'invention avec le transistor bipolaire tel que décrit dans le document FR-2 626 406 mais dont la région active de base est supprimée, et qui est compatible avec la technologie MOS. Autrement dit, le transistor fabriqué selon l'invention ne présente que des avantages au niveau de la compatibilité de son mode de fabrication avec les techniques actuellement utilisées, ce qui facilite son implantation pour créer de nouveaux circuits intégrés.

## Revendications

1. Procédé de fabrication d'un transistor à effet de champ vertical à canal N ou P, caractérisé en ce qu'il consiste :
- à déposer une couche (11) de silicium polycristallin d'un certain type de conductivité sur une face principale d'un substrat semi-conducteur (2) tel qu'un substrat en silicium présentant une zone active formant une région de drain (D) ayant un type de conductivité prédéterminé correspondant au type de canal du transistor ;
- à former dans la couche (11) de silicium polycristallin, une région active de source (S), ayant le type de conductivité prédéterminé, en saillie sur la face principale du substrat (2) ;
- à former une région active de grille (G) par implantation ionique d'ions ayant un type de conductivité opposé au type de conductivité prédéterminé, dans le substrat (2) de part et d'autre de la région de source (S) pour réaliser une jonction (J) ;
- à former des espaceurs (14) sur les parois latérales de la source (S) en recouvrant la face du substrat (2) d'une couche (13) d'oxyde de silicium sur une épaisseur e, et en effectuant une gravure anisotrope dans cette couche (13) d'oxyde de silicium sur une épaisseur e pour ne laisser subsister l'oxyde de silicium que sur les parois latérales de la source ;
- à éliminer la région de grille précédemment obtenue par implantation ionique de façon à creuser le substrat à la surface inférieure des espaceurs (14) formés sur les parois latérales de la région de source (S) ;
- à former un siliciure de métal (MG,MS) sur les régions de grille (G) et de source (S) pour réaliser les contacts de grille et de source, les espaceurs (14) évitant toute continuité entre les contacts de grille et de source ;
- à éliminer la couche de métal déposée sur les espaceurs (14) au cours de l'étape précédente ; et
- à faire une nouvelle implantation ionique pour reformer la jonction (J) de la région de grille (G).

2. Procédé de fabrication selon la Revendication 1, caractérisé en ce qu'il consiste pour former la région de source (S) du transistor, à déposer une couche photosensible (12) sur la couche (11) de silicium polycristallin, à réaliser des opérations de masquage et de photogravure pour éliminer la couche photosensible (12) et le silicium polycristallin de part et d'autre de la région de source (S).

3. Procédé de fabrication selon la Revendications 1 ou 2, caractérisé en ce qu'il consiste à former le siliciure de métal (MG,MS) sur les régions de grille (G) et de source (S) par un procédé salicide, connu en soi.

4. Procédé de fabrication selon l'une quelconque des Revendications précédentes, caractérisé en ce que les opérations d'implantation ionique pour former la jonction de la région de grille (G) et de siliciuration des régions de source et de grille sont réalisées d'une manière autopositionnée par rapport à la source (S) en saillie sur le substrat (2).
à effectuer ensuite l'opération de dépôt sélectif de siliciure précitée de la région de grille (G) et de la région de source (S), et à faire une nouvelle implantation ionique pour reformer la jonction (J) de la région de grille (G).

## Patentansprüche

1. Verfahren zur Herstellung eines N- oder P-Kanal-Feldeffekttransistors, dadurch gekennzeichnet, daß es folgendes umfaßt:
- dio Abscheidung einer Schicht (11) aus polykristallinem Silicium eines bestimmten Leitfähigkeitstyps auf einer Hauptfläche eines halbleitenden Substrates (2) wie Siiciumsubstrat mit einer aktiven Zone, die einen Senkenbereich (D) mit einem vorherbestimmten Leitfähigkeitstyp bildet, der dem Kanaltyp des Transistors entspricht;
- die Ausbildung eines als Quelle aktiven Bereichs (S) mit dem vorherbestimmten Leitfähigkeitstyp in der Schicht (11) des polykristallinen Siliciums und der aus der Hauptfläche des Substrates (2) herausragt,
- die Ausbildung eines aktiven Gitterbereiches (G) durch das Implantieren von Ionen mit einer dem vorherbestimmten Leitfähigkeitstyp im Substrat (2) entgegengesetzten Leitfähigkeitstyp, auf jeder Seite des Quellbereiches (S), um eine Sperrschicht (J) herzustellen;
- die Ausbildung von Distanzstücken (14) auf den Seitenwänden auf der Quelle (S) durch das Bedecken der Fläche des Substrates (2) mit einer Schicht (13) aus Siliciumoxid bis zu einer Dicke *e* und dem Durchführen anisotropen Ätzens der besagten Schicht (13) aus Siliciumoxid auf eine Dicke *e*, um Siliciumoxid nur an den Seitenwänden der Quelle zu belassen;
- das Entfernen des vorher durch das Implantieren von Ionen erhaltenen Gitterbereiches, um das Substrat von der Bodenfläche der Distanzstücke (14), die auf den Seitenwänden des Quellbereiches (S) ausgebildet sind, abzutrennen;
- das Ausbilden eines Metallsilicides (MG, MS) auf den Gitter(G)- und Quell(S)-Bereichen um die Kontakte der Steuerelektrode und der Quelle auszubilden, wobei die Distanzstücke (14) jede Verbindung zwischen den Steuerelektroden- und Quellkontakten verhindern,
- das Entfernen der während des vorhergegangenen Schrittes auf den Distanzstücken (14) abgeschiedenen Metallschicht; und
- die Durchführung einer erneuten Implantation von Ionen, um die Sperrschicht (J) des Gitterbereiches (G) wiederherzustellen.

2. Herstellverfahren nach Anspruch 1, dadurch gekennzeichnet, daß zur Ausbildung des Quellbereichs (S) des Transistors das Verfahren aus der Abscheidung einer photosensitiven Schicht (12) auf der Schicht (11) aus polykristallinen Silicium und der Durchführung von Maskierungs- und Photoätzvorgängen, um die photosensitive Schicht 12 und das polykristalline Silicium auf beiden Seiten das Quellbereiches (S) zu entfernen, besteht.

3. Herstellverfahren nach Anspruch 1 oder 2, dadurch gekennzeichnet, daß es in der Ausbildung des Metallsilicids auf den Gitter (G)- und Quell (S)- Bereichen mit einer an sich bekannten Salicidmethode besteht.

4. Herstellverfahren nach irgendeinem der vorhergehenden Ansprüche, dadurch gekennzeichnet, daß die Maßnahmen zur Implantierung von Ionen zur Ausbildung der Sperrschicht des Gitterbereiches und zur Ausbildung des Silicids auf den Quell- und Gitterbereichen auf eine relativ zur Quelle (S), die aus dem Substrat (2) herausragt, selbstpositionierende Weise durchgeführt werden, dann in der Durchführung der oben erwähnten Maßnahme zur selektiven Abscheidung von Silicid auf dem Gitterbereich (G) und auf dem Quellbereich (S), und in der erneuten Implantierung von Ionen, um die Sperrschicht (J) des Gitterbereiches (G) wiederherzustellen.

## Claims

1. A method of manufacturing an N or P channel field effect transistor, characterized in that it consists :
- in depositing a layer (11) of polycrystalline silicon of a certain conductivity type on a main face of a semiconductive substrate (2) such as a silicon substrate having an active zone forming a drain region (D) of a predetermined conductivity type corresponding to the channel type of the transistor ;
- in forming a source active region (S) having the predetermined conductivity type in the layer (11) of polycrystalline silicon and projecting from the main face of the substrate (2) ;
- in forming an active grid region (G) by implanting ions having a conductivity type opposite to the predetermined conductivity type in the substrate (2) on either side of the source region (S) to make a junction (J) ;
- in forming spacers (14) on the side walls on the source (S) by covering the face of the substrate (2) with a layer (13) of silicon oxide to a thickness e, and in performing anisotropic etching of said layer (13) of silicon oxide to a thickness e so as to leave silicon oxide only on the side walls of the source ;
- in eliminating the grid region previously obtained by implanting ions so as to cut away the substrate from the bottom surface of the spacers (14) formed on the side walls of the source region (S) ;
- in forming a metal silicide (MG, MS) on the grid (G) and source (S) regions to form the gate and source contacts, the spacers (14) avoiding any continuity between the gate and source contacts ;
- in eliminating the metal layer deposited on the spacers (14) during the preceding step ; and
- in performing an implanting ions again to reform the junction (J) of the gate region (G).

2. A method of manufacturing according to claim 1, characterized in that for forming the source region (S) of the transistor, the method consists in depositing a photosensitive layer (12) on the layer (11) of poly-crystalline silicon, and in performing masking and photoetching operations to eliminate the photosensitive layer (12) and the polycrystalline silicon on either side of the source region (S).

3. A method of manufacturing according to claim 1 or 2, characterized in that it consists in forming the metal silicide on the grid (G) and source (S) regions by a salicide method, known per se.

4. A method of manufacturing according to any of the preceding claims, characterized in that the operations of implanting ions to form the junction of the grid region and of siliciding the source and grid regions are performed in a manner that is automatically positioned relative to the source (S) projecting from the substrate (2), then in performing the above-mentioned operation of selectively depositing silicide for the grid region (G) and for the source region (S), and in implanting ions again to reform the junction (J) of the grid region (G).
